# EUROPÄISCHE PATENTSCHRIFT

(11) **EP 1 971 448 B1**
(45) Veröffentlichungstag und Bekanntmachung des Hinweises auf die Patenterteilung: **29.10.2014**
(21) Anmeldenummer: 07702643.3
(22) Anmeldetag: 10.01.2007
(51) Int. Cl.: B08B 7/00, H01J 37/32

(54) **VERFAHREN UND VORRICHTUNG ZUR BEHANDLUNG EINER OBERFLÄCHE UM DIESE VON VERUNREINIGUNGEN ZU BEFREIEN**
METHOD AND APPARATUS FOR TREATING A SURFACE IN ORDER TO FREE IT OF IMPURITIES
PROCEDE ET DISPOSITIF DE TRAITEMENT D'UNE SURFACE POUR LA DEBARRASSER DES IMPURETES

(30) Priorität: 14.01.2006 DE 102006001891
(43) Veröffentlichungstag der Anmeldung: 24.09.2008
(73) Patentinhaber: Fachhochschule Hildesheim / Holzminden / Göttingen, 31134 Hildesheim (DE)
(72) Erfinder: VIÖL, Wolfgang, 37139 Adelebsen (DE)
(74) Vertreter: REHBERG HÜPPE + PARTNER
(86) Internationale Anmeldenummer: PCT/EP2007/000139
(87) Internationale Veröffentlichungsnummer: WO 2007/080102

(56) Entgegenhaltungen:
- EP-A- 1 454 705
- WO-A-2004/051729
- WO-A-2004/053185
- DE-A1- 19 747 841
- US-A1- 2005 061 783

## Beschreibung

### TECHNISCHES GEBIET DER ERFINDUNG

Die Erfindung bezieht sich auf ein Verfahren zur Behandlung einer Oberfläche, um diese von Verunreinigungen zu befreien, das die Merkmale des Oberbegriffs des unabhängigen Patentanspruchs 1 aufweist. Weiterhin bezieht sich die Erfindung auf eine-entsprechende Vorrichtung zur Behandlung einer Oberfläche mit den Merkmalen des Oberbegriffs des unabhängigen Patentanspruchs 9.

### STAND DER TECHNIK

Das Behandeln einer Oberfläche mit einem Plasma, insbesondere um die Oberfläche von Verunreinigungen zu befreien, ist grundsätzlich bekannt und wird als Plasmareinigen oder auch als Plasmaätzen bezeichnet. In aller Regel erfolgt diese Art der Behandlung einer Oberfläche unter einem reduzierten Druck, um die Erzeugung des Plasmas mit einer elektrischen Hochspannung zu erleichtern. Es ist aber auch bekannt, dass Plasma unter Atmosphärendruck z.B. durch eine dielektrisch behinderte Entladung einer Wechselhochspannung zu erzeugen. In diesem Fall basiert die Behandlung der Oberfläche mit dem Plasma auf der oxidierenden Wirkung des in den Plasmazustand überführten Prozessgases. Die Wirkung des Plasmas auf organische Verunreinigungen einer Oberfläche entspricht einem oxidativen Abbau im Sinne einer kalten Verbrennung, der bei moderatem Energieeintrag in die Oberfläche erfolgt.

Weiterhin sind sogenannte Plasmageneratoren für verschiedene Anwendungen bekannt, die aus einer Elektrodenanordnung ein Plasma in eine unter Atmosphärendruck stehende Umgebung abgeben. Das Plasma wird in der Elektrodenanordnung z.B. durch dielektrisch behinderte Entladung, Coronaentladung, Bogenentladung oder Hochfrequenzentladung erzeugt und in Form eines Plasmastrahls, d.h. eines ionisierten Gasstrahls oder eines sogenannten Plasmajets, emittiert.

Auch die Behandlung von Oberfläche mit Laserlicht, um diese von Verunreinigungen zu befreien, ist grundsätzlich bekannt. Dabei kann ausgenutzt werden, dass das Laserlicht aufgrund seiner Wellenlänge selektiv von den Verunreinigungen und nicht von der zu reinigenden Oberfläche absorbiert wird, um den Energieeintrag auf die zu entfernenden Verunreinigungen zu konzentrieren.

Aus der US 6,734,388 B2 ist es bekannt, mit fokussiertem Laserlicht eine Plasmastoßwelle zur Reinigung einer Oberfläche von Verunreinigungen zu erzeugen.

Verfahren und Vorrichtungen zur Behandlung einer Oberfläche, insbesondere um diese von Verunreinigungen zu befreien, sind aus den Korean Patent Abstracts zu KR 10 2002 0000203 bis 0000206 A bekannt. Hier erfolgt im ersten Schritt ein Plasmaätzen der Oberfläche unter reduziertem Druck und in einem sich anschließenden zweiten Schritt eine Behandlung der Oberfläche mit Laserlicht, um durch statische elektrische Aufladung an der Oberfläche anhaftende Teilchen zu entfernen.

Verfahren und Vorrichtungen zur Behandlung einer Oberfläche mit Laserlicht und einem durch elektrische Hochspannung induzierten physikalischen Plasma sind aus der EP 1 454 705 A1 bekannt. Ziel ist dabei die thermische Bearbeitung eines Werkstücks. Das Werkstück umfasst einen Werkstückgrundkörper aus einem Metall, insbesondere aus Aluminium, und eine Oberflächenbeschichtung, wie beispielsweise eine Oxidschicht, und soll mittels eines Laserstrahls bearbeitet werden. Die Oberflächenbeschichtung wird vor und/oder während der Laserbearbeitung mit Hilfe eines Plasmas abgetragen. Auf diese Weise wird die Werkstückoberfläche des Werkstückgrundkörpers mit Hilfe des Plasmas gereinigt und vorbehandelt. Das Plasma wird durch Anlegen einer Wechselspannung zwischen dem Werkstück und einer nicht abbrennbaren Wolframelektrode angelegt, während ein inertes Prozessgas, wie Argon, Helium oder eine Mischung der beiden Gase zugeführt wird.

Aus der DE 102 10 518 A1 sind ein Verfahren zum selektiven Abtragen einer oder mehrerer Schichten von einem Triebswerkbauteil bekannt, bei denen die zugeführte Energie von der jeweils abzutragenden Schicht so stark absorbiert wird, dass die Abtragsschwelle des jeweiligen Materials der abzutragenden Schicht überschritten wird, während diese Abtragsschwelle in dem zu erhaltenden Untergrund nicht erreicht wird. Zur Überwachung dieses Vorgangs ist ein Spektrometer mit einer Steuereinheit derart verbunden, dass die verfahrensspezifischen Kennwerte während des Abtragens der jeweiligen Schicht mittels spektroskopischer Methoden bestimmbar sind und zur selbstregulierenden Prozessbegrenzung dienen. Als Energiequelle wird je nach Anwendung beispielsweise eine Laserenergiequelle oder eine Hochenergie-Plasma-Puls-Quelle verwendet.

Ein Verfahren und eine Vorrichtung zur Behandlung einer Oberfläche, um diese von Verunreinigungen zu befreien, mit den Merkmalen der Oberbegriffe der unabhängigen Patentansprüche 1 und 9 sind aus der US 2005/0061783 A1 bekannt. Hier wird die Oberfläche bereichsweise mit dem Laserlicht aufgeheizt, um die reaktive Wirkung des Plasmas räumlich selektiv zu verbessern.

Aus der WO 2004/051729 A2 ist ein Verfahren zum Behandeln von Oberflächen von zu bindenden Substraten mit einem atmosphärischen Plasma vor dem Bonden bekannt. Dabei wird die Oberfläche mit einem hierauf abgestimmten Prozessgas gereinigt.

Aus der WO 2004/053185 A1 ist ein Verfahren zur Konservierung von Metalloberflächen mittels einer Plasmabehandlung in einer Reaktivgasatmosphäre bekannt, bei dem die Metalloberflächen einer dielektrischen Barriereentladung unter Atmosphärendruck ausgesetzt werden. Die Plasmabehandlung bewirkt auch eine Reinigung der Metalloberflächen.

Aus der DE 197 47 841 A1 ist eine Absaugvorrichtung zur Lasermaterialbearbeitung und Laserreinigung bekannt, bei der eine Absaugglocke vorgesehen ist, durch die ein Laserstrahl auf eine zu bearbeitende oder zu reinigende Oberfläche eines Werkstücks geleitet wird, und bei der die durch das Auftreffen des Laserstrahls auf das Werkstück entstehende Plasmawolke durch ein Spülgas unterspült und aus der Absaugglocke abgesaugt wird.

### AUFGABE DER ERFINDUNG

Der Erfindung liegt die Aufgabe zugrunde, ein neues Verfahren und eine neue Vorrichtung zur Behandlung einer Oberfläche aufzuzeigen, mit denen eine Oberfläche behandelbar ist, um sie in kurzer Zeit zu reinigen.

### LÖSUNG

Die Aufgabe der Erfindung wird durch ein Verfahren mit den Merkmalen des unabhängigen Patentanspruchs 1 und durch eine Vorrichtung mit den Merkmalen des unabhängigen Patentanspruchs 9 gelöst. Bevorzugte Ausführungsformen des neuen Verfahrens sind in den abhängigen Patentansprüchen 2 bis 8 definiert, während die abhängigen Patentansprüche 10 und 11 bevorzugte Ausführungsformen der neuen Vorrichtung betreffen.

### BESCHREIBUNG DER ERFINDUNG

Bei dem neuen Verfahren wirken das Laserlicht und das durch elektrische Hochspannung induzierte physikalische Plasma gleichzeitig auf die zu behandelnde Oberfläche ein. Hierdurch ergibt sich überraschenderweise nicht nur die Summe der Effekte des Laserlichts und des physikalischen Plasmas sondern auch ein hierüber deutlich hinaus gehender Synergieeffekt in Bezug auf die Abtragleistung des neuen Verfahrens bei verschiedenen Verunreinigungen auf verschiedenen Oberflächen. So kann einerseits der Energieeintrag pro Fläche, der zum Reinigen einer Oberfläche mit Laserlicht oder mit einem physikalischen Plasma erforderlich ist, bei dem neuen Verfahren, bei dem das Laserlicht und das physikalische Plasma gleichzeitig auf die zu behandelnde Oberfläche einwirken, so reduziert werden, dass unerwünschte Einwirkungen auf eine zu reinigende Oberfläche, wie beispielsweise Beschädigungen, vermieden werden. Mit der Reduzierung des Energieeintrags steigt auch die Flächenleistung des neuen Verfahrens. Andererseits können auch solche Verunreinigungen, die bislang weder mit Laserlicht noch mit einem physikalischen Plasma sinnvoll entfernt werden konnten, mit dem neuen Verfahren wirkungsvoll beseitigt werden.

So wirken bei dem neuen Verfahren das Laserlicht und/oder das physikalische Plasma jeweils in einer Intensität unterhalb einer Abtragschwelle auf die Oberfläche ein, und dennoch wird bei dem neuen Verfahren insgesamt eine sehr gute Reinigungsleistung erzielt. In bevorzugten Ausführungsformen des neuen Verfahrens wirkt sowohl das Laserlicht als auch das physikalische Plasma jeweils in einer Intensität unterhalb der Abtragschwelle auf die Oberfläche ein.

Insbesondere dann, wenn bei dem neuen Verfahren die Intensität des physikalischen Plasmas klein gehalten wird, kann die Abtragsselektivität des monochromatischen Laserlichts ausgenutzt und diese Selektivität auf das gesamte neue Verfahren übertragen werden. Hierzu ist die Wellenlänge des Laserlichts beispielsweise so abzustimmen, dass sie überwiegend von Verunreinigungen auf der Oberfläche und nicht von der Oberfläche selbst absorbiert wird.

Umgekehrt kann auch das Plasma auf bestimmte Substanzen an der Oberfläche abgestimmt werden, indem es beispielsweise aus einem Prozessgas erzeugt wird, dessen Zusammensetzung auf von der Oberfläche zu entfernende Verunreinigung abgestimmt ist. Konkret kann das physikalische Plasma z. B. transparente Substanzen auf der Oberfläche so mattieren, dass sie anschließend größere Intensitäten des Laserlichts absorbieren und dadurch ganz entfernt werden.

Als Plasmaquelle für das Plasma wird ein an sich bekannter Plasmagenerator verwendet, und das Plasma liegt in Form eines auch unter Atmosphärendruck einsetzbaren ionisierten Gasstroms vor, der ohne irgendwelche Evakuierungsmaßnahmen auf die zu behandelnde Oberfläche gerichtet werden kann. D. h. das Plasma wird als sogenanntes Remote-Plasma ohne Beteiligung der zu behandelnden Oberfläche als Gegenelektrode erzeugt. Konkret wird das Laserlicht gemeinsam mit einem Arbeitsgasstrom zwischen zwei Elektroden hindurch auf die zu behandelnde Oberfläche gerichtet, wobei zwischen den Elektroden die Hochspannung angelegt wird, um das Plasma durch Gasentladung in dem Arbeitsgasstrom zu zünden, der das Plasma an die zu behandelnde Oberfläche anbläst.

Wenn das Plasma in der Plasmaquelle durch dielektrisch behinderte Entladung erzeugt wird, kann dies besonders problemlos, d.h. vor allem mit begrenztem technischen Aufwand im Bereich des Atmosphärendrucks oder in vorteilhafter Weise sogar bei einem oberhalb des Atmosphärendrucks in der Umgebung der Plasmaquelle liegenden Druck erfolgen.

Bei der Durchführung des neuen Verfahrens mit dem Laserlicht und dem physikalischen Plasma von der Oberfläche abgelöste Verunreinigungen können durch eine Gasströmung von der Oberfläche entfernt werden. Zur Bereitstellung dieser Gasströmung kann die Oberfläche während ihrer Behandlung mit dem Laserlicht und dem Plasma abgesaugt werden.

Bei der neuen Vorrichtung zur Behandlung einer Oberfläche, insbesondere um diese von Verunreinigungen zu befreien, sind die Lichtquelle und die Plasmaquelle Teil eines Bearbeitungskopfs, mit dem das Laserlicht und das Plasma zur selben Zeit in einen die Oberfläche aufnehmenden Behandlungsbereich ausrichtbar sind. Mit diesem Bearbeitungskopf können aufgrund der Synergieeffekte des Laserlichts und des Plasmas im Vergleich zu der von dem Bearbeitungskopf an die Oberfläche abgegebenen Energie sehr große Flächen der Oberfläche behandelt werden.

Bei der neuen Vorrichtung kann eine aus dem Behandlungsbereich absaugende Absaugeinrichtung ebenfalls in dem Bearbeitungskopf, aber auch separat davon vorgesehen sein.

Weitere Merkmale der neuen Vorrichtung wurden bereits zumindest mittelbar durch die Erläuterung des neuen Verfahrens beschrieben.

### KURZBESCHREIBUNG DER FIGUREN

Im Folgenden wird die Erfindung anhand in den Figuren dargestellter bevorzugter Ausführungsbeispiele weiter erläutert und beschrieben.

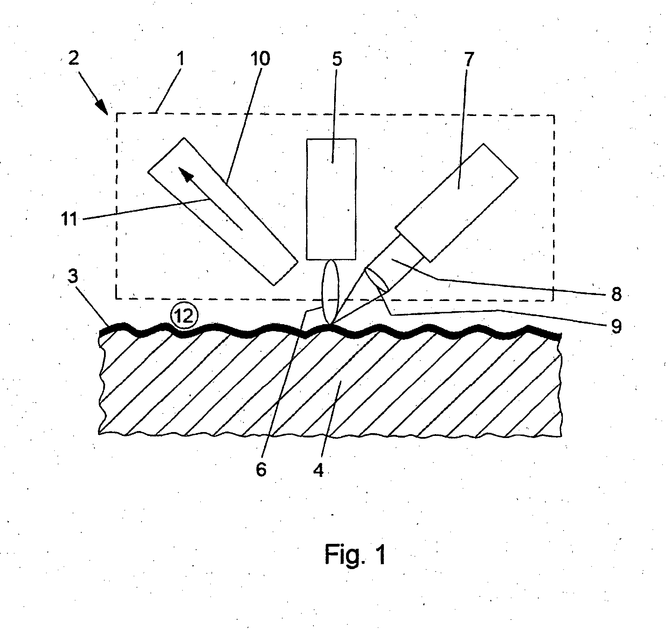

- **Fig. 1**: zeigt schematisch den Aufbau einer Vorrichtung und deren Verwendung zur Behandlung einer Oberfläche, um diese von Verunreinigungen zu befreien, wobei weder die Vorrichtung noch das Verfahren unter die Patentansprüche fallen; und
- **Fig. 2**: zeigt schematisch den Aufbau einer Ausführungsform der neuen Vorrichtung und deren Verwendung zur Durchführung des neuen Verfahrens ebenfalls bei der Behandlung einer Oberfläche, um diese von Verunreinigungen zu befreien.

### FIGURENBESCHREIBUNG

**F**ig. 1 zeigt die Komponenten eines Bearbeitungskopfs 1 einer Vorrichtung 2 zur Behandlung einer Oberfläche 3 eines in einem Behandlungsbereich angeordneten Objekts 4, um insbesondere hier nicht separat dargestellte Verunreinigungen von der Oberfläche 3 zu entfernen. Das Objekt 4 kann beispielsweise ein mit einer Farbe auf Kunstharzbasis verunreinigter Stein sein. Der Bearbeitungskopf 1 umfasst eine Plasmaquelle 5, die ein Plasma 6 in Form eines ionisierten Gasstroms, d. h. hier konkret in Form eines so genannten Plasmajets, auf die Oberfläche 3 hin abgibt. Weiterhin umfasst der Bearbeitungskopf 1 eine Lichtquelle 7, die Laserlicht 8 in Form eines Laserstrahls abgibt, der von einer Linse 9 in denselben Bereich der Oberfläche 3 fokussiert wird, in dem auch das Plasma 9 auf die Oberfläche 3 auftrifft. Die Lichtquelle 7 kann ein Laser oder auch das Ende eines Lichtleiters sein. Die Plasmaquelle 5 erzeugt das Plasma 6 z.B. durch Entladung einer elektrischen Wechselhochspannung in einem Prozessgas, wobei diese Entladung dielektrisch behindert sein und bei einem Druck etwas oberhalb des Bewegungsdrucks des Bearbeitungskopfs 1 erfolgen kann. Bei der elektrischen Wechselhochspannung kann es sich konkret um eine bipolare Wechselhochspannung handeln, die aus einzelnen, untereinander beabstandeten Paaren von Pulsen entgegen gesetzter Polarität besteht. Unter Einwirkung des Plasmas 6 und des Laserlichts 8 von der Oberfläche 3 abgelöste Verunreinigungen werden mit einer Absaugeinrichtung 10, die hier Teil des Bearbeitungskopfs 1 ist, von der Oberfläche 3 abgesaugt. Auf diese Weise wird auch die unkontrollierte Freisetzung von Ionen und Radikalen aus dem Plasma 6 in die Umgebung des Bearbeitungskopfs 1 unterbunden. Der Bearbeitungskopf 1 kann über die hier dargestellten Komponenten hinaus Sensoren zur Überwachung der Behandlung der Oberfläche 3 mit dem Plasma 6 und dem Laserlicht 8 aufweisen. Derartige Sensoren können beispielsweise die Temperatur der Oberfläche 3 im Bereich der gemeinsamen Einwirkung des Plasmas 6 und des Laserlichts 8 auf die Oberfläche 3 erfassen oder auch die Temperatur und/oder die Zusammensetzung einer durch die Absaugeinrichtung 10 verlaufenden Absaugströmung 11.

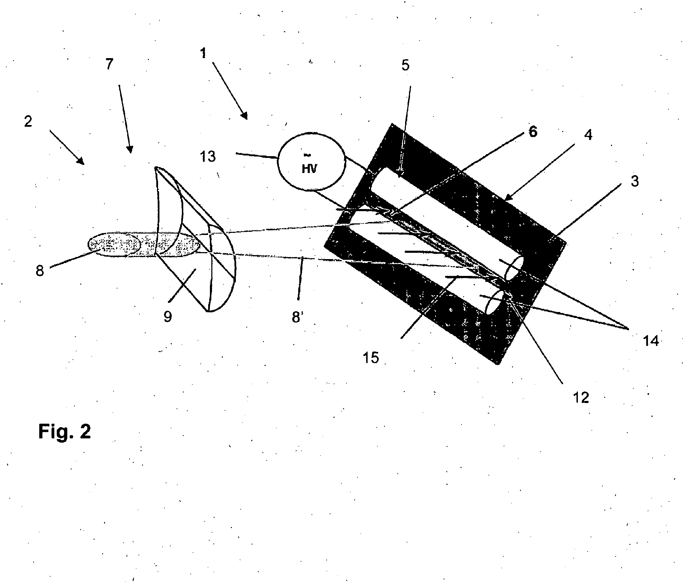

Die in Fig. 2 gezeigte Vorrichtung 2 weist einen Bearbeitungskopf 1 auf, in dem die Lichtquelle 7 und die Plasmaquelle 5 weitgehend kombiniert sind. So fokussiert die Lichtquelle 7 das Laserlicht 8 mit Hilfe einer als Zylinderlinse ausgebildeten Linse 9 auf eine Linie. Das linienfokussierte Laserlicht 8' wird von der Lichtquelle 7 zwischen zwei Elektroden 14 der Plasmaquelle 5 hindurch auf die Oberfläche 3 des Objekts 4 gerichtet. Zwischen den Elektroden 14 der Plasmaquelle 5 hindurch wird gleichzeitig ein Arbeitsgasstrom 15 auf die Oberfläche 3 gerichtet, und es liegt eine Wechselhochspannung von einer Hochspannungsquelle 13 an, die das Plasma 6 in dem Arbeitsgasstrom 15 durch Gasentladung zündet. Diese Gasentladung ist durch eine hier nicht sichtbare dielektrische Abschirmung mindestens einer der Elektroden 14 dielektrisch behindert. Die dielektrische Behinderung erleichtert das Zünden des Plasmas bei Atmosphärendruck mit geringem technischem Aufwand bezüglich der Hochspannungsquelle 13. Durch die langgestreckte Ausbildung der Elektroden 14 und die damit einhergehende Erstreckung des Plasmas 6, das mit dem Arbeitsgasstrom 15 an die Oberfläche 3 angeblasen wird, in Verbindung mit dem linienfokussierten Laserlicht 8' entsteht ein langgestreckter Behandlungsraum 12, in dem die Oberfläche 3 des Objekts 4 zu einem Zeitpunkt gleichzeitig mit dem Laserlicht 8 und dem Plasma 6 behandelt wird. Dabei kann das Laserlicht 8 alternativ zu der Zylinderlinse oder zusätzlich zwischen den Elektroden 14 hindurch über den Behandlungsraum 12 hinweg bewegt werden, um die gesamte an den Behandlungsraum 12 angrenzende Oberfläche 3 gleichmäßig mit dem Laserlicht zu beaufschlagen oder abzuscannen. Mittels einer relativen Querverschiebung des Objekts 4 zu dem Behandlungsraum 12 kann die gesamte Oberfläche 3 des Objekts in kurzer Zeit abgescannt und damit gereinigt werden. Der freie Abstand der Elektroden 14 liegt typischerweise in einem Bereich von 0,5 bis 5 mm. Die Dicke des linienfokussierten oder verschwenkten Laserlichts 8' ist im Bereich ist der Elektroden 14 sinnvoller Weise nicht größer einzustellen.

Bei Erprobung der vorliegenden Erfindung wurden die folgenden Ergebnisse erzielt:

Unter reiner Einwirkung von Laserlicht 8 konnte der Beginn der Ätzung einer transparenten PMMA-Filmschicht auf der Oberfläche 3 bei einer Energiedichte von 0,045 J/cm² beobachtet werden. Bei zusätzlicher Beaufschlagung der PMMA-Filmschicht mit dem Plasma 6 unter Verwendung von Sauerstoff als das Prozessgas, aus dem das Plasma ausgebildet wurde, verschob sich der Beginn der Ätzung auf eine Energiedichte von 0,008 Joule/cm² des Laserlichts. Dabei war die Intensität des Plasmas 6 zu gering, um für sich allein die Ätzung der PMMA-Filmschicht herbeizuführen. Die Wellenlänge des Laserlichts 8 bei dieser Erprobung des neuen Verfahrens betrug 248 nm und wurde von einem Excimer-Laser bereitgestellt.

Weitere Erprobungen der vorliegenden Erfindung unter Verwendung von Laserlicht 8 einer Wellenlänge von 1064 nm von einem Nd:YAG-Laser ergab, dass bei Einsatz eines Plasmas 6, das selbst nicht in der Lage war, eine Kunstharzschicht zu entfernen, eine erhebliche Erhöhung der Flächenleistung des mit konstanter Intensität eingesetzten Laserlichts beim Entfernen der Kunstharzschicht erzielt werden konnte. Konkret lag die Erhöhung der Flächenleistung in einem Fall beim 3,5-fachen.

Ein Vergleichsversuch, einen Baumberger Sandstein, der mit gelbem Sprühlack verunreinigt war, mit Laserlicht von 1064 nm zu reinigen, ergab ein ebenso unbefriedigendes Ergebnis wie ein Vergleichsversuch, dieselbe Verunreinigung nur mit einem physikalischen Plasma aus dem Prozessgassauerstoff zu entfernen. Die angestrebte Reinigung wurde auch nicht durch eine Erhöhung der Intensität oder eine Verlängerung der Dauer der Behandlung mit dem Laserlicht oder dem Plasma erzielt. Eine Kombination des Laserlichts 8 mit dem Plasma 6 gemäß der vorliegenden Erfindung jedoch ergab einen synergistischen Effekt und führte zu der gewünschten Reinigung der Sandsteinoberfläche von dem Sprühlack.

**BEZUGSZEICHENLISTE**

| | | | |
|---|---|---|---|
| 1 | Bearbeitungskopf | 11 | Absaugströmung |
| 2 | Vorrichtung | 12 | Behandlungsbereich |
| 3 | Oberfläche | 13 | Hochspannungsquelle |
| 4 | Objekt | 14 | Elektrode |
| 5 | Plasmaquelle | 15 | Arbeitsgasstrom |
| 6 | Plasma | | |
| 7 | Lichtquelle | | |
| 8 | Laserlicht | | |
| 9 | Linse | | |
| 10 | Absaugeinrichtung | | |

## Patentansprüche

1. Verfahren zur Behandlung einer Oberfläche (3), um diese von Verunreinigungen zu befreien, wobei die Oberfläche (3) Laserlicht (8) und einem durch elektrische Hochspannung induzierten physikalischen Plasma (6) ausgesetzt wird, wobei das Laserlicht (8) und das physikalische Plasma (6) gleichzeitig auf die Oberfläche einwirken, wobei das Plasma (6) als ionisierter Gasstrom auf die Oberfläche (3) gerichtet wird und wobei das Laserlicht (8) oder das physikalische Plasma (6) oder beide in einer Intensität unterhalb einer Abtragschwelle auf die Oberfläche (3) einwirken, **dadurch gekennzeichnet, dass** das Laserlicht (8) gemeinsam mit einem Arbeitsgasstrom (15) zwischen zwei Elektroden (14) hindurch auf die Oberfläche (3) gerichtet wird, wobei die Hochspannung zwischen den Elektroden (14) anliegt.

2. Verfahren nach Anspruch 1, **dadurch gekennzeichnet, dass** sowohl das Laserlicht (8) als auch das physikalische Plasma (6) jeweils in einer Intensität unterhalb einer Abtragschwelle auf die Oberfläche (3) einwirkt.

3. Verfahren nach Anspruch 1 oder 2, **dadurch gekennzeichnet, dass** eine Wellenlänge des Laserlichts (8) so abgestimmt wird, dass das Laserlicht (8) überwiegend von Verunreinigungen auf der Oberfläche (3) und nicht von der Oberfläche (3) selbst absorbiert wird.

4. Verfahren nach einem der Ansprüche 1 bis 3, **dadurch gekennzeichnet, dass** das Plasma (6) aus einem Prozessgas erzeugt wird, dessen Zusammensetzung auf von der Oberfläche (3) zu entfernende Verunreinigungen abgestimmt ist.

5. Verfahren nach einem der Ansprüche 1 bis 4, **dadurch gekennzeichnet, dass** das Plasma (6) in einer Plasmaquelle (5) durch dielektrisch behinderte Entladung bei einem Gasdruck von mehr als 900 hPa erzeugt und mit der Plasmaquelle (5) auf die Oberfläche (3) gerichtet wird.

6. Verfahren nach Anspruch 5, **dadurch gekennzeichnet, dass** das Plasma (6) in der Plasmaquelle (5) durch dielektrisch behinderte Entladung bei einem Gasdruck oberhalb des Atmosphärendrucks in der Umgebung der Plasmaquelle (5) erzeugt und mit der Plasmaquelle (5) auf die Oberfläche (3) gerichtet wird.

7. Verfahren nach einem der Ansprüche 1 bis 6, **dadurch gekennzeichnet, dass** die Behandlung der Oberfläche (3) bei Atmosphärendruck, der in der Umgebung der Plasmaquelle (5) herrscht, erfolgt.

8. Verfahren nach einem der Ansprüche 1 bis 7, **dadurch gekennzeichnet, dass** die Oberfläche (3) während ihrer Behandlung mit dem Laserlicht (8) und dem Plasma (6) abgesaugt wird.

9. Vorrichtung zur Behandlung einer Oberfläche nach dem Verfahren nach einem der Ansprüche 1 bis 8, um diese von Verunreinigungen zu befreien, mit einer Laserlicht (8) abgebenden Lichtquelle (7) und einer ein Plasma (6) durch elektrische Hochspannung erzeugenden Plasmaquelle (5), wobei die Lichtquelle (7) und die Plasmaquelle (5) Teil eines Bearbeitungskopfs (1) sind,
wobei die Plasmaquelle (5) das Plasma (6) als ionisierten Gasstrom erzeugt und wobei der Bearbeitungskopf (1) einen Betriebsmodus aufweist, in dem er das Laserlicht (8) oder das physikalische Plasma (6) oder beide in einer Intensität unterhalb einer Abtragschwelle abgibt, **dadurch gekennzeichnet, dass** die Lichtquelle (7) derart angeordnet ist, dass das Laserlicht (8) von der Lichtquelle (7) zwischen zwei Elektroden (14) der Plasmaquelle (5) hindurch in den Behandlungsbereich (12) eintritt, wobei ein Arbeitsgasstrom (15) der Plasmaquelle (5) zwischen den Elektroden (14) hindurch in den Behandlungsbereich (12) eintritt und die Hochspannung zwischen den Elektroden (14) anliegt und mit dem Bearbeitungskopf (1) das Laserlicht (8) und das Plasma (6) zur selben Zeit in einen die Oberfläche (3) aufnehmenden Behandlungsbereich ausrichtbar sind.

10. Vorrichtung nach Anspruch 9, **dadurch gekennzeichnet, dass** sich der Behandlungsbereich (12) auf Atmosphärendruck in der Umgebung der Plasmaquelle (5) befindet.

11. Vorrichtung nach Anspruch 9 oder 10, **dadurch gekennzeichnet, dass** eine aus dem Behandlungsbereich (12) absaugende Absaugeinrichtung (10) vorgesehen ist.

## Claims

1. Method of treating a surface (3) to free it from impurities, wherein the surface (3) is subjected to laser light (8) and to a physical plasma (6) induced by electric high voltage, wherein the laser light (8) and the physical plasma (6) simultaneously act upon the surface, wherein the plasma (6) is directed onto the surface (3) as an ionized gas flow, and wherein the laser light (8) or the physical plasma (6) or both act upon the surface (3) at an intensity below an erosion threshold, **characterised in that** the laser light (8) together with the working gas flow (15) is directed onto the surface (3) passing between two electrodes (14), wherein the high voltage is present between the electrodes (14).

2. Method according to claim 1, **characterised in that** both the laser light (8) and the physical plasma (6) each acts upon the surface (3) at an intensity below an erosion threshold.

3. Method according to claim 1 or 2, **characterised in that** a wavelength of the laser light (8) is tuned in such a way that the laser light (8) is predominantly absorbed by the impurities on the surface (3) and not by the surface (3) itself.

4. Method according to any of the claims 1 to 3, **characterised in that** the plasma (6) is generated of a process gas whose composition is adapted to the impurities to be removed from the surface (3).

5. Method according to any of the claims 1 to 4, **characterised in that** the plasma (6) is generated in a plasma source (5) by dielectric barrier discharge at a gas pressure of less than 900 hPa and is directed onto the surface (3) by means of the plasma source (5).

6. Method according to claim 5, **characterised in that** the plasma (6) is generated in the plasma source (5) by dielectric barrier discharge at a gas pressure above the atmospheric pressure in the surroundings of the plasma source (5) and is directed onto the surface (3) by means of the plasma source (5).

7. Method according to any of the claims 1 to 6, **characterised in that** the treatment of the surface (3) is effected at that atmospheric pressure present in the surroundings of the plasma source (5).

8. Method according to any of the claims 1 to 7, **characterised in that** the surface (3), during its treatment with the laser light (3) and the plasma (6) is sucked off.

9. Apparatus for treating a surface according to the method according to any of the claims 1 to 8 to free it from impurities, comprising a light source (7) supplying laser light and a plasma source (5) generating a plasma (6) by electrical high voltage, wherein the light source (7) and the plasma source (5) are parts of a processing head (1), wherein the plasma source (5) generates the plasma (6) as an ionized gas flow, and wherein the treating head (1) has an operation mode in which it supplies the laser light (8) or the physical plasma (6) or both at an intensity below an erosion threshold, **characterised in that** the light source (7) is arranged in such a way that the laser light (8) from the light source (7) enters the treatment area (12) passing between two electrodes (14) of the plasma source (5), wherein a gas flow (15) of the plasma source (5) enters the treatment area (12) passing between the electrodes (14), and the high voltage is present between the electrodes (14), and wherein, by means of the treating head, the laser light (8) and the plasma (6) are simultaneously directable into a treatment area accommodating the surface (3).

10. Apparatus according to claim 9, **characterised in that** the treatment area (12) is at that atmospheric pressure present in the surroundings of the plasma source (5).

11. Apparatus according to claim 9 or 10, **characterised in that** a sucking off device (10) is provided which sucks out of the treatment area (12).

## Revendications

1. Procédé pour le traitement d'une surface (3) pour y éliminer des impuretés, ladite surface (3) étant exposée à une lumière laser (8) et à un plasma (6) physique induit par une haute tension électrique, la lumière laser (8) et le plasma (6) physique agissant simultanément sur la surface, le plasma (6), sous forme de flux gazeux ionisé, étant dirigé sur la surface (3), et la lumière laser (8) ou le plasma (6) physique ou tous deux agissant sur la surface (3) avec une intensité inférieure au seuil d'enlèvement, **caractérisé en ce que** la lumière laser (8), conjointement avec un flux de gaz de travail (15), est dirigée sur la surface (3) en passant entre deux électrodes (14), la haute tension étant appliquée entre les électrodes (14).

2. Procédé selon la revendication 1, **caractérisé en ce que** tant la lumière laser (8) que le plasma (6) physique agissent chacun sur la surface (3) avec une intensité inférieure au seuil d'enlèvement.

3. Procédé selon la revendication 1 ou 2, **caractérisé en ce qu'**une longueur d'onde de la lumière laser (8) est ajustée de telle sorte que la lumière laser (8) est absorbée en majeure partie par les impuretés sur la surface (3) et non pas par la surface (3) elle-même.

4. Procédé selon l'une quelconque des revendications 1 à 3, **caractérisé en ce que** le plasma (6) est généré à partir d'un gaz du processus, dont la composition est ajustée aux impuretés à éliminer sur la surface (3).

5. Procédé selon l'une quelconque des revendications 1 à 4, **caractérisé en ce que** le plasma (6) est généré dans une source plasma (5) par une décharge à barrière diélectrique en présence d'une pression de gaz supérieure à 900 hPa et est dirigé sur la surface (3) au moyen de la source plasma (5).

6. Procédé selon la revendication 5, **caractérisé en ce que** le plasma (6) est généré dans la source plasma (5) par une décharge à barrière diélectrique en présence d'une pression de gaz supérieure à la pression atmosphérique dans l'environnement de la source plasma (5) et est dirigé sur la surface (3) au moyen de la source plasma (5).

7. Procédé selon l'une quelconque des revendications 1 à 6, **caractérisé en ce que** le traitement de la surface (3) est effectué à la pression atmosphérique qui règne dans l'environnement de la source plasma (5).

8. Procédé selon l'une quelconque des revendications 1 à 7, **caractérisé en ce que** les impuretés sur la surface (3) sont aspirées pendant le traitement de celle-ci au moyen de la lumière laser (8) et du plasma (6).

9. Dispositif pour le traitement d'une surface selon le procédé selon l'une quelconque des revendications 1 à 8, pour y éliminer des impuretés, comportant une source lumineuse (7) émettant une lumière laser (8) et une source plasma (5) générant un plasma (6) par une haute tension électrique, la source lumineuse (7) et la source plasma (5) faisant partie d'une tête de traitement (1), la source plasma (5) générant le plasma (6) sous forme de flux gazeux ionisé et la tête de traitement (1) possédant un mode de fonctionnement dans lequel elle émet la lumière laser (8) ou le plasma (6) physique ou les deux avec une intensité inférieure à un seuil d'enlèvement, **caractérisé en ce que** la source lumineuse (7) est disposée de telle sorte que la lumière laser (8) sortant de la source lumineuse (7) entre dans la zone de traitement (12) en passant entre deux électrodes (14) de la source plasma (5), un flux de gaz de travail (15) de la source plasma (5) entrant dans la zone de traitement (12) en passant entre les électrodes (14), et la haute tension est appliquée entre les électrodes (14), et la lumière laser (8) et le plasma (6) peuvent être dirigées avec la tête de traitement (1) au même moment dans une zone de traitement contenant la surface (3).

10. Dispositif selon la revendication 9, **caractérisé en ce que** la zone de traitement (12) est mise à la pression atmosphérique dans l'environnement de la source plasma (5).

11. Dispositif selon la revendication 9 ou 10, **caractérisé en ce qu'**il est prévu un dispositif d'aspiration (10) aspirant les impuretés hors de la zone de traitement (12).
